# EUROPÄISCHE PATENTSCHRIFT

(11) **EP 2 372 802 B1**
(45) Veröffentlichungstag und Bekanntmachung des Hinweises auf die Patenterteilung: **07.10.2015**
(21) Anmeldenummer: 11002621.8
(22) Anmeldetag: 30.03.2011
(51) Int. Cl.: H01L 41/047, H01L 41/053, H01L 41/23, H01L 41/29

(54) **Elektromechanischer Wandler und Verfahren zur Herstellung des elektromechanischen Wandlers**
Electromechanical converter and method for producing an electromechanical converter
Convertisseur électromécanique et procédé de fabrication du convertisseur électromécanique

(30) Priorität: 30.03.2010 DE 102010013565
(43) Veröffentlichungstag der Anmeldung: 05.10.2011
(73) Patentinhaber: iNDTact GmbH, 97076 Würzburg (DE)
(72) Erfinder: Petricevic, Raino, 97074 Würzburg (DE); Reigl, Herbert, 97906 Faulbach (DE)
(74) Vertreter: Gassner, Wolfgang

(56) Entgegenhaltungen:
- EP-A1- 1 168 463
- EP-A2- 1 199 758
- WO-A1-03/047008
- DE-A1- 10 218 936

## Beschreibung

Die Erfindung betrifft einen elektromechanischen Wandler nach dem Oberbegriff des Patentanspruchs 1 sowie ein Verfahren zur Herstellung des elektromechanischen Wandlers nach dem Oberbegriff des Patentanspruchs 2. Die Erfindung betrifft ferner Verwendungen des elektromechanischen Wandlers.

Elektrisch kontaktiert werden elektromechanische Funktionselemente wie z. B. piezoelektrische Keramiken über Elektroden aus Metallfolie, Metallgewebe, gedruckte Schaltung (PCB) oder siebgedruckte Leiterbahnen. Die Elektroden werden dabei zusammen mit der Piezokeramik in eine isolierende Matrix zu Piezokompositen (RTM Verfahren) vergossen oder mit diesen verklebt oder laminiert. Siebgedruckte Leiterbahnen eignen sich besonders für die Herstellung filigraner, dauerrobuster, definiert strukturierter und besonders inniger Elektrodierung von elektromechanischen Wandlern im Laminierpressverfahren.

Aus der DE 100 51 784 C1 ist ein elektromechanisches Funktionsmodul mit mindestens einem Wandler innerhalb mehrerer Faser-Deckschichten bekannt. Dabei werden Elektroden aus gewebten oder porösen elektrisch leitfähigen Materialien (z. B. Kohlefasergewebe oder Metallgewebe, Metallnetze, leitfähig bedruckte Gewebe) verwendet welche durch einen RTM-Formgießverfahren in einer Matrix (z. B. Epoxid) fixiert werden. Hierbei ergeben sich keinerlei Grenzflächen und im Idealfall besteht die gesamte Einheit aus durchgängigem Matrixmaterial wie Epoxid. Nachteil dieser Wandlertechnologie ist die Beschränkung auf die einfachste Elektrodiervariante (Flächenelektrode) und das aufwändigere RTM-Verfahren. Eine sinnvolle Verwendung von z. B. faserartigen Funktionselementen (piezoelektrische Keramikfasern) ist damit nicht möglich. Zudem sind keine Lösungswege einer zuverlässigen Kontaktierung bei Integrationsanwendungen aufgezeigt.

Aus der DE 102 18 936 A1 ist ein Verfahren zur Herstellung elektromechanischer Wandler mit einer aus PTFE hergestellten Trägerschicht bekannt, auf der Leiterbahnen als Elektroden aufgedruckt sind. Da diese Elektroden mit den Funktionselementen (z. B. piezoelektrischen Keramiken) in Kontakt stehen und auf der anderen Seite isoliert sein müssen, werden die Leiterbahnen in der Regel nach außen (zum Rand hin) verlängert und von dort aus zur Signalein- und -auskopplung durchkontaktiert. Die externe Kontaktierung vor allem von gedruckten Leiterbahnen erfolgt nach dem Stand der Technik durch Klemmen, Leitkleben oder Löten abisolierter Elektrodenbereiche. Letzteres gilt nur bei Verwendung lötfähiger Leiterbahnen. Diese Kontakte stellen jedoch in der Regel Sollbruchstellen und damit einen Schwachpunkt des elektromechanischen Wandlers dar.

Für Hochfrequenzanwendungen ist eine möglichst wandlernahe Durchkontaktierung erforderlich. Beispielsweise um den Empfang elektromagnetischer Störsignale durch lange Leitungen zu minimieren. D. h. die Durchkontaktierung ist u. U. in einem Bereich starker mechanischer Beanspruchung. Jedoch sind auch hier keine Wege einer zuverlässigen Außenkontaktierung für Integrationsanwendungen aufgezeigt.

Die WO 03/047008 A1 offenbart einen elektromechanischen Wandler, bei dem zwischen zwei faserverstärkte Schichten aus einem Kompositmaterial eine piezoelektrische Schicht mit einer darauf befindlichen elektrisch isolierenden Schicht eingeschaltet ist.

Die EP 1 168 463 A1 betrifft einen Faserverbundwerkstoff mit einem darin integrierten piezoelektrischen Aktor oder Sensor. Die elektrischen Zuleitungen zum Aktor bzw. Sensor sind in Form dünner Drähte ausgebildet, die senkrecht zu den Laminatlagen des Faserverbundwerkstoffs geführt sind.

Der Erfindung liegt die Aufgabe zugrunde, einen elektromechanischen Wandler der eingangs genannten Art so zu verbessern, dass die elektrische Kontaktierung gut leitfähig und mechanisch hoch beanspruchbar ist und der Wandler einfach hergestellt werden kann und mechanisch robust ist.

Diese Aufgabe wird durch die in den Patentansprüchen 1, 2 und 13 bis 15 angegebene Erfindung gelöst. Weiterbildungen und vorteilhafte Ausführungsbeispiele der Erfindung sind in den Unteransprüchen angegeben.

Die Erfindung hat den Vorteil, dass eine integrale elektrische Kontaktierung zwischen Elektroden (z. B. gedruckten Leiterbahnen auf Polymerbasis), einem elektromechanischen Funktionselement (z. B. piezoelektrische Keramik) und weiteren elektrischen Kontakten (z. B. Lötpunkte, metallische Leiterbahnen, elektronische Bauteile) besteht, die mit möglichst niedrigem Kontaktwiderstand zu den Elektroden bzw. Leiterbahnen und mechanisch stabil angeordnet sind.

Die Erfindung hat weiterhin den Vorteil, dass der elektromechanische Wandler in einem einfachen Laminier-Press-Verfahren schnell und kostengünstig herstellbar ist.

Die Erfindung hat zusätzlich den Vorteil, dass eine Sekundärstruktur aus einem Metall-CFK-Prepreg-Komposit (oder allgemein einem Komposit aus Metall und/oder einem durch leitfähige Komponenten verstärkten Prepreg) in die Elektrodenschicht (Leiterplattenschicht) vor der Aushärtung (Vernetzung) integriert wird, welcher je nach Ausführung praktisch von beiden Seiten zugänglich gemacht werden kann. Als leitfähiger Bestandteil dieses Prepregs kommen elektrisch leitfähige Fasern, Gewebe, Vliese, Netze, Garne, Schnüre oder Partikel sowohl aus Metall als auch aus Kohlenstoff in Betracht. Bei einer möglichen besonderen Ausführung können die Kontakte direkt über der Kontaktierung mittels Löt- oder Klemmkontakten abgegriffen werden oder elektronische Bauteile direkt daran befestigt werden. In einer weiteren Ausführung lassen sich mechanisch entkoppelte Kontakte herstellen.

Überraschenderweise ist diese Methode zur Kontaktierung extrem robust, wesentlich einfacher und zudem kostengünstiger herzustellen als nach dem Stand der Technik, da keine speziellen bzw. teuren Verfahren oder Klebstoffe verwendet werden müssen. Zudem hat sich gezeigt, dass im Gegensatz zu den gängigen Verfahren kein aufwändiger Prozessschritt erforderlich ist. Verblüffenderweise zeigt sich, dass die Verarbeitung sogar in einen für die Fabrikation der elektromechanischen Wandler bereits bestehenden Prozessschritt integriert werden kann. Dies erwies sich zudem als Vorteil bezüglich der Anhaftung der Kontakte, da Materialien zum Einsatz kommen, welche bei den gleichen Aushärtebedingungen für Temperatur, Druck, Vakuum etc. verarbeitet werden können. Dadurch kommt es zu einem besonders innigen und stabilen Verbund aller Komponenten.

Des Weiteren hat sich überraschend gezeigt, dass weitere funktionelle Komponenten wie Elektronik, Abschirmung sowie Oberflächenstrukturierungen sehr einfach im Herstellprozess aufgebracht bzw. integriert werden können.

Die Erfindung wird anhand eines Ausführungsbeispiels, das in der Zeichnung dargestellt ist, näher erläutert. Es zeigen:
- Fig. 1:: einen schematischen elektromechanischen Wandler mit piezoelektrischen Keramikfasern, und
- Fig. 2:: einen schematischen elektromechanischen Wandler mit verschiedenen Kontaktierungsausführungen.

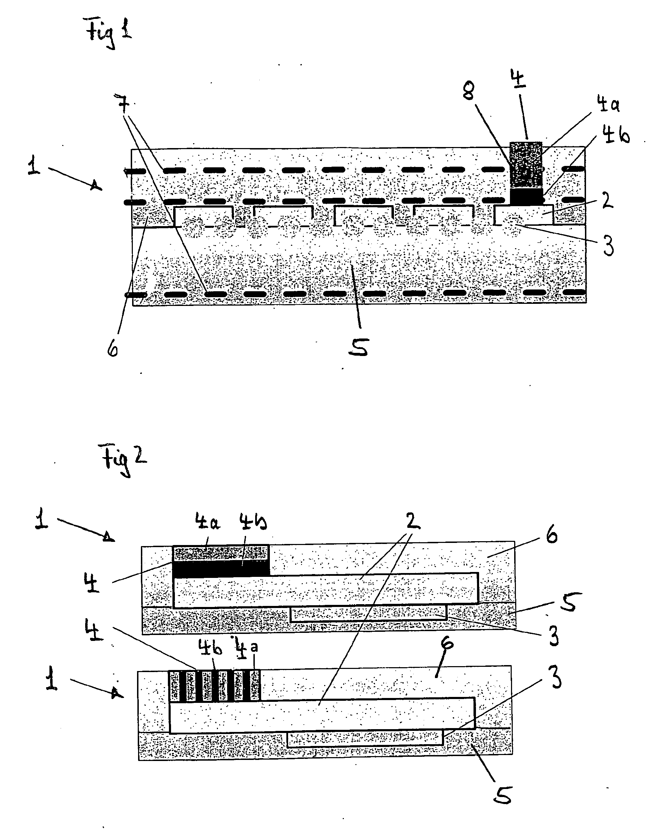

In Fig. 1 der Zeichnung ist ein elektromechanischer Wandler 1 mit integrierten Elektroden 2, Kontaktierungen 4 und piezoelektrischen Funktionselementen 3 dargestellt, der aus einem Sandwich aus faserverstärktem Polymerprepreg bzw. Klebefilm als Trägerschicht 5, aus einem symmetrisch verstärkten Polymerprepreg bzw. Klebefilm als Deckschicht 6, siebgedruckten Leiterbahnen 2 als Elektroden, piezoelektrische Fasern als Funktionselementen 3 und einem elektrisch leitfähigen Verbund aus Metall und kohlefaserverstärktem Polymerprepreg als Kontaktierung 4 hergestellt ist. Es wird entsprechend der Verarbeitungsparameter für die Prepregs bzw. die Klebefilme mit Hilfe einer Presse unter definiertem Druck zu einem elektromechanischen Wandler 1 ausgehärtet.

Dabei zeichnet sich das Herstellungsverfahren dadurch aus, dass die Kupferpads 4a zusammen mit vorzugsweise elektrisch leitenden Prepregs 4b, vorzugsweise aus kohlefaserverstärktem Epoxid, vorverklebt und vorzugsweise hinterher auf die gewünschte Größe zugeschnitten werden. Die Zuschnitte werden in möglichst konforme Aussparungen des Deckschichtprepregs 6, (z. B. aus demselben faserverstärktem Epoxid bzw. Klebefilm wie die Trägerschicht 5, eingelegt. Die Schichtdicke des Kupferpad-CFK-Prepreg-Verbundes 4a, 4b als Kontaktierung 4 sollte in etwa der Dicke der Deckschicht 6 Prepregs entsprechen. Siebgedruckte Elektroden als Leiterbahnen auf einer Trägerfolie werden auf den beidseitig symmetrisch mit Glasfasergewebeverstärkung versehene Deckschicht 6 Prepreg fixiert und unter den Verarbeitungsparametern für den Prepreg in einer Laminierpresse (z. B. einer einfachen Zweiplatten-Pressvorrichtung) unter definiertem Druck ausgehärtet. Optimale Ergebnisse lassen sich unter Verwendung von Presspolstern erzielen.

Die Kontaktierungen 4 liegen dabei zumindest teilweise (z. B. punktuell) über den gewünschten Leiterbahnabschnitten. Die Trägerfolie wird nach dem Laminieren und Aushärten von der Deckschicht 6 abgezogen (entformt), so dass die Leiterbahnen bzw. Elektroden 2 auf dieser Deckschicht 6 in leitfähigem Verbund zu den Kontaktierungen 4 verbleiben. Man erhält eine ebene Leiterplatte mit integralen Durchkontaktierungen 4.

Alternativ lassen sich durchkontaktierte Leiterplatten auch dadurch herstellen, dass die Deckschicht 6 als beidseitige symmetrisch mit Fasergewebeverstärkung versehene Epoxid-Prepregs mit den eingelegten Kontaktierungen 4 aus Kupfer-CFK-Prepreg-Verbund, jedoch ohne Elektroden bzw. Leiterbahnen, in einer heizbaren Pressvorrichtung unter definiertem Druck zur Deckschichtfolie 6 ausgehärtet wird, und die Elektroden z. B. als Leiterbahnen hinterher auf diese Deckschichtfolie und die Kontaktierung 4 siebgedruckt werden. Auch hierdurch erhält man eine Leiterplatte mit integralen Durchkontaktierungen 4. Nach Plasmareinigung der durchkontaktierten Leiterplatten werden die Funktionselemente 3 (z. B. piezoelektrische Keramiken und/oder Elektronikkomponenten) auf die Elektrodenseite der Leiterplatte durch einen weiteren Laminierprozess aufgebracht. Dabei wird das Funktionselement 3 (z. B. piezoelektrische Keramik) mit Hilfe eines faserverstärkten Polymerprepregs in Form eines Klebefilms, vorzugsweise auf Basis von Epoxid als Trägerschicht 5 auf den Leiterbahnen 2 der durchkontaktierten Deckschicht 6 (Leiterplatte) selbsthaftend vorfixiert. Im Falle von filigranen Funktionselementen (z. B. piezoelektrische Keramikfasern) werden diese mit einer Separiervorrichtung ausgerichtet. Die Stärke (Dicke, E-Modul) der Trägerschicht wird über das Verstärkungsgewebe eingestellt und hat vorzugsweise in etwa die gleiche Stärke (Dicke, E-Modul) wie die Deckschicht 6.

Der Laminierprozess erfolgt bei den Verarbeitungsparametern für das verwendete Prepreg oder Klebefilmmaterial in einer Laminierpresse (z. B. zwischen zwei heizbaren Pressplatten) unter definiertem Druck. Optimale Ergebnisse lassen sich unter Verwendung von Presspolstern erzielen. Man erhält einen elektromechanischen Wandler 1 mit integraler und hochrobuster Durchkontaktierung 4.

Nach dem Schritt der Plasmareinigung können alternativ oder zusätzlich zur vorherigen Kontaktierungsmethode die Kontaktierungen 4 auch auf den zuvor gefertigten und plasmagereinigten Leiterplatten aufgebracht werden. Dazu werden Kupferpadfolien 4a einseitig an gewünschten Abschnitten (z. B. punktuell an den Enden) oder vollflächig mit elektrisch leitenden Prepregs 4b (z. B. CFK-Prepregs oder Kupfernetz-Prepregs) vorverklebt, auf die gewünschte Größe zugeschnitten, und an ausgewählte Positionen der plasmagereinigten Leiterbahnen (Elektroden) 2 selbsthaftend fixiert. Überstehendes Kupfer der Pads 4a kann mit Epoxid-Klebefilm oder faserverstärktem-Prepreg isoliert werden.

Die Fixierung der Wandlerelemente 3 auf den Elektroden 2 und die Aushärtung erfolgt analog zum ersten Verfahren. Dadurch werden lötfähige Kontakte 4 in die Matrix integriert. Diese alternativen oder zusätzlichen Lötkontakte 4 lassen sich durch überstehende Kupferfolie in beliebiger Länge mit oder ohne elektrische Isolierung erzeugen und somit in der Anwendung mechanisch von der Funktionsschicht bzw. Elektrode 2 entkoppeln. Damit sind isolierte Kontaktdurchführungen z. B. durch Faserverbundbauteile mit Durchkontaktierungen oder Herausführung der Kontakte an beliebiger Stelle möglich. In Fig. 2 der Zeichnung werden zwei elektromechanische Wandler 1 mit unterschiedlichen Kontaktierungen 4 dargestellt. Dabei zeigt die obere Darstellung einen Metall-Polymerprepregverbund 4 als Kontaktierung mit einem oberen Kupferpad 4a unter dem parallel ein elektrisch leitender Prepreg aus einem leitfähigen Polymer (z. B. Kohlefaserverstärktes Epoxid) verklebt ist. In der unteren Darstellung ist eine Kontaktierung mit mehreren vertikal-parallel angeordneten Kupferpads 4a dargestellt, die mit elektrisch leitenden Prepregs 4b verklebt sind. Dies entspricht beispielsweise einem Kupfergewebeprepreg.

Durch das Einfügen oder Laminieren von Abreißgewebe oder weiteren Schichten wie z. B. behandelte Metallfolien auf den jeweiligen Außenflächen von Deckschicht (6) und/oder Trägerschicht (5), lassen sich zusätzliche Funktionsschichten wie z. B. definierte Rauigkeiten und/oder Schutzschichten auf den Außenflächen des elektromechanischen Wandlers im Rahmen des obigen Herstellungsprozesses erzeugen bzw. integrieren.

## Patentansprüche

1. Elektromechanischer Wandler (1), der mindestens eine untere Trägerschicht (5) und mindestens ein darauf angeordnetes elektrisches und/oder elektromechanisches Funktionselement (3) umfasst, das mit elektrischen Leiterbahnen (2) verbunden ist, die ihrerseits mit elektrischen Kontaktierungen (4) verbunden und mit einer Deckschicht (6) abgedeckt sind und aus der mindestens zwei der elektrischen Kontaktierungen (4) herausgeführt sind, **dadurch gekennzeichnet, dass** die Träger und Deckschicht (5, 6) als mechanisch stabilisierte Polymerprepreg-Schichten ausgebildet sind, wobei eine Kontaktierung (4) zumindest auf einem Abschnitt der Leiterbahnen (2) aus einem elektrisch leitfähigen Verbund aus mechanisch stabilisierten Polymerprepreg (4b) und Metall (4a) bestehen, und der Gesamtverbund des elektromechanischen Wandlers (1) ausgehärtet ist.

2. Verfahren zur Herstellung eines elektromechanischen Wandlers (1) nach Patentanspruch 1, **dadurch gekennzeichnet, dass** auf die Trägerschicht (5) die elektromechanischen oder elektrischen Funktionselemente (3) und darauf die elektrischen Leiterbahnen (2) mit der Deckschicht (6) auflaminiert werden, wobei die Kontaktierungen (4) durch eine entsprechende Aussparung (8) aus der Deckschicht (6) herausgeführt werden, **dadurch gekennzeichnet, dass** mindestens eine Schicht verstärktes Polymerprepreg (4b) und eine Schicht Metall (4a) zu elektrisch leitfähigen Kontaktierungen (4) vorverklebt und entsprechend der vorgegebenen Größe zugeschnitten werden, wobei diese dann in die entsprechende Aussparung (8) der Deckschicht (6) aus symmetrisch verstärktem Polymerprepreg gelegt und/oder darauf die elektrischen Leiterbahnen (2) angeordnet und auf die mit Kontakten versehene Deckschicht (6) laminiert werden, und dabei die Prepregs ausgehärtet werden, wonach hierauf die Funktionselemente (3) mittels einer verstärkten Polymerprepreg Trägerschicht (5) auf den Leiterbahnen (2) der leiterseitig plasmagereinigten und durchkontaktierten Deckschicht (6) fixiert und in einem weiteren Laminierprozess ausgehärtet wird.

3. Verfahren nach Anspruch 2, **dadurch gekennzeichnet, dass** die Leiterbahnen (2) auf eine Zwischenträgerfolie aufgebracht werden, wobei die Leiterbahnen (2) von der Zwischenträgerfolie auf eine Polymerfolie als Deckschicht (6) übertragen werden, wobei die Polymerfolie (6) aus einem symmetrisch verstärkten Polymerprepreg hergestellt wird, wobei der symmetrisch verstärkte Polymerprepreg an bestimmten Positionen mit Aussparungen (8) ausgestanzt und mit Kontaktierungen (4) (Kontaktpads) versehen ist, wobei die Kontaktierungen (4) aus einem elektrisch leitfähigen Verbund aus Metall (4a)und Polymerprepreg (4b) oder aus einem Metallnetz- oder Metallgewebeverstärktem Polymerprepreg bestehen, wobei der Verbund der Deckschicht (6), der Leiterbahnen (2) und der Kontaktierungselemente (4) entsprechend der Verarbeitungsparameter für die Prepregs zu einer durchkontaktierten ebenen Polymerleiterplattenfolie (Polymerfolie mit elektrischen Leiterbahnen) ausgehärtet wird, wonach hierauf diese Polymerleiterplattenfolie leiterbahnseitig plasmagereinigt wird, wonach hierauf die Funktionselemente (3) mittels der verstärkten Polymerprepreg Trägerschicht (5) fixiert werden und dieser Verbund in einem weiteren Laminierprozess ausgehärtet wird.

4. Verfahren nach Anspruch 2, **dadurch gekennzeichnet, dass** die Leiterbahnen (2) auf eine ausgehärtete und durchkontaktierte Polymer-Deckschicht (6) aufgebracht werden, wonach hierauf die mit Leiterbahnen (2) versehene Deckschicht (6) leiterbahnseitig plasmagereinigt wird, wonach hierauf die Funktionselemente (3) mittels der verstärkten Polymerprepreg Trägerschicht (5) fixiert werden und dieser Verbund in einem weiteren Laminierprozess ausgehärtet wird.

5. Verfahren nach Ansprüchen 2, 3 und 4, **dadurch gekennzeichnet, dass** die Funktionselemente (3) mit einer Separiervorrichtung ausgerichtet werden.

6. Verfahren nach Ansprüchen 2, 3, 4, 5 und 6, **dadurch gekennzeichnet, dass** die Prepregs mechanisch durch Fasern, Schnüre, Filamente, Gewebe, Vliese, Garn oder Netze aus Glas, Polymer, Metall oder Kohlenstoff verstärkt sind und die mechanische Verstärkung so eingestellt wird, dass entweder die Dehnung der Funktionselemente (3) möglichst wenig behinder wird oder das E-Modul für den Wandler gezielt eingestellt wird.

7. Verfahren nach einem der Ansprüche 2 bis 5, **dadurch gekennzeichnet, dass** über kontaktierte Leiterbahnen (2) mittels der Kontaktierung (4) auch Elektronikkomponenten als Funktionselemente (3)integriert werden, die sowohl aus aktiven und passiven SMDs und integrierten Schaltungen bestehen.

8. Verfahren nach einem der Ansprüche 2 bis 5, **dadurch gekennzeichnet, dass** auf die Oberfläche der Faser Deckschicht (6) vor der Aushärtung eine weitere Funktionsschicht zur Abschirmung gegen elektromagnetische Strahlung, Korrosion und Wasser oder zur Tarnung laminiert wird.

9. Verfahren nach dem Anspruch 8, **dadurch gekennzeichnet, dass** die Funktionsschicht eine dünne und/oder geerdete Metallfolie ist.

10. Verfahren nach einem der Ansprüche 2 bis 9, **dadurch gekennzeichnet, dass** die Oberflächenrauigkeit des Wandlers (1) im Laminierverfahren ein oder beidseitig gezielt eingestellt wird.

11. Verfahren nach einem der Ansprüche 2 bis 10, **dadurch gekennzeichnet, dass** mindestens zwei Funktionselemente (3) oder Wandler (1) zu einem Stack verbunden werden.

12. Verwendung eines Wandlers nach Anspruch 1, **dadurch gekennzeichnet, dass** ein Wandler (1) so in einem Faserverbundwerkstoff integriert oder darauf appliziert wird, dass mit ihm eine sensorische und aktuatorische Funktionalität erzielt wird.

13. Verwendung eines Wandlers nach Anspruch 1, **dadurch gekennzeichnet, dass** der Wandler (1) im niederfrequenten Bereich zur Modalanalyse, Schwingungserzeugung , Detektion, Erdbebensensorik, Schwingungstilgung oder als dynamischer Dehnungsmessstreifen eingesetzt wird.

14. Verwendung eines Wandlers nach Anspruch 1, **dadurch gekennzeichnet, dass** der Wandler (1) als akustischer Wandler (Lautsprecher, Mikrophon) oder hydrostatischer Akustik-Wandler (Hydrophone) eingesetzt wird.

15. Verwendung eines Wandlers nach Anspruch 1, **dadurch gekennzeichnet, dass** der Wandler (1) im hochfrequenten Bereich zur Ultraschallerzeugung und Detektion oder zur eingebetteten zerstörungsfreien Prüfung oder Inspektion mittels geführter Wellen, Impedanz-Sensorik oder Impakterkennung eingesetzt wird.

## Claims

1. An electromechanical converter (1) comprising at least one lower substrate layer (5) and at least one electrical and/or electromechanical functional element (3) arranged thereon such that is connected with electrical conductor paths (2), which are in turn connected with electrical contacts (4) and covered with a cover layer (6) and at least two of the electrical contacts (4) are lead through it, **characterized in that** the substrate and the cover layer (5, 6) are designed as mechanically stabilized polymer prepreg layers, wherein one contact (4) at least on a section of the electrical conductor paths (2) consists of an electrically conducting composite consisting of mechanically stabilized polymer prepreg (4b) and metal (4a), and the total composite of the electromechanical converter (1) is cured.

2. A method for producing an electromechanical converter (1) according to Patent Claim 1, **characterized in that** on the substrate layer (5) the electromechanical or electrical functional elements (3) and thereon the electrical conductor paths (2) are laminated with the cover layer (6), wherein the contacts (4) are led through the cover layer (6) through a corresponding recess (8), **characterized in that** at least one layer of reinforced polymer prepreg (4b) and a layer of metal (4a) are previously conglutinated to form electrically conductive contacts (4) and are cut according to the corresponding specified size, wherein these are then placed into the corresponding recess (8) of the cover layer (6) made of symmetrically reinforced polymer prepreg and/or on it the electric conductor paths (2) are arranged and laminated onto the cover layer (6) which is provided with contacts, and thereby the prepregs are cured, subsequent to which thereon the functional elements (3) are fixated by means of a reinforced polymer prepreg substrate layer (5) on the conductor paths (2) of the cover layer (6) on the conducting side of the cover layer (6) which has been plasma-cleaned and plated through and is cured in a further lamination process.

3. The method according to Claim 2, **characterized in that** the conductor paths (2) are applied to a subcarrier film, wherein the conductor paths (2) are transferred by the subcarrier film to a polymer film as cover layer (6), wherein the polymer film (6) is made of a symmetrically reinforced polymer prepreg, wherein in the symmetrically reinforced polymer prepreg recesses (8) are stamped out at certain positions and provided with contacts (4) (contact pads), wherein the contacts (4) consist of an electrically conducting composite consisting of metal (4a) and polymer prepregs (4b) or of a polymer prepreg reinforced with a metal net or a metal fabric, wherein the composite of the cover layer (6), the conductor paths (2) and the contact elements (4) are cured into a plated-through flat polymer electric circuit board film (polymer film with electric conductor paths) according to the processing parameters for the prepregs, whereupon this polymer electric circuit board film is plasma-cleaned on the part of the conductor paths, whereupon the functional elements (3) are fixated upon it by means of the reinforced polymer prepreg substrate layer (5) and this composite is cured in a further lamination process.

4. The method according to Claim 2, **characterized in that** the conductor paths (2) are applied to a cured and plated-through polymer cover layer (6), whereupon thereon, the cover layer (6) which is provided with conductor paths (2) is plasma-cleaned on the part of the conductor paths, whereupon the functional elements (3) are fixed by means of the reinforced polymer prepreg substrate layer (5) and this composite is cured in an additional lamination process.

5. The method according to Claims 2, 3 and 4, **characterized in that** the functional elements (3) are aligned with a separating unit.

6. The method according to Claims 2, 3, 4, 5 and 6, **characterized in that** the prepregs are reinforced mechanically by fibers, cords, filaments, fabrics, fleece, yarn or nets made of glass, polymers, metal or carbon, and the mechanical reinforcement is adjusted such that either the strain of the functional elements (3) is impeded as little as possible or the modulus of elasticity for the converter is adjusted in a targeted way.

7. The method according to one of the Claims 2 through 5, **characterized in that** electronic components are also integrated as functional elements (3) via contacted conductor paths (2) by means of the contact (4) that consist of active and passive SMDs and integrated circuits.

8. The method according to one of Claims 2 through 5, **characterized in that** on the surface of the fiber cover layer (6) an additional functional layer is laminated prior to curing to provide a shield against electro-magnetic radiation, corrosion and water or for camouflage.

9. The method according to Claim 8, **characterized in that** the functional layer is a thin and/or grounded metal film.

10. The method according to one of the Claims 2 through 9, **characterized in that** the surface roughness of the converter (1) is adjusted in a targeted manner on one or on both sides by the lamination process.

11. The method according to one of the Claims 2 through 10, **characterized in that** at least two functional elements (3) or the converter (1) are connected into a stack.

12. A use of a converter (1) according to Claim 1, **characterized in that** a converter (1) is integrated into a fiber composite material or applied thereon such that a sensing and actuating functionality is achieved thereby.

13. The use of a converter according to Claim 1, **characterized in that** the converter (1) is used in the low frequency range for modal analysis, for generating oscillation, for detection, for seismic detection, for the cancellation of vibration or as dynamic resistance strain gauge.

14. The use of a converter according to Claim 1, **characterized in that** the converter (1) is used as acoustic converter (loudspeaker, microphone) or as hydrostatic acoustic converter (hydrophone).

15. The use of a converter according to Claim 1, **characterized in that** the converter (1) is used in the high frequency range to generate and detect ultrasound and for embedded non-destructive testing or inspection by means of guided waves, impedance detection or impact detection.

## Revendications

1. Convertisseur électromécanique (1) qui comporte au moins une couche support inférieure (5) et au moins un élément fonctionnel électrique et/ou électromécanique (3) disposé sur cette dernière qui est relié à des pistes conductrices électriques (2), lesquelles sont reliées à des contacts électriques (4) et recouvertes d'une couche de revêtement (6) et laquelle est sortie d'au moins deux des contacts électriques (4), **caractérisé en ce que** les supports et la couche de revêtement (5, 6) sont réalisés sous forme de couches de prépreg polymère stabilisées mécaniquement, **en ce qu'**un contact (4) se compose au moins sur un segment des pistes conductrices (2) d'un composite électriquement conducteur en prépreg polymère (4b) stabilisé mécaniquement et en métal (4a), et la totalité du composite du convertisseur électromécanique (1) est durcie.

2. Procédé de fabrication d'un convertisseur électromécanique (1) selon la revendication 1, **caractérisé en ce que** les éléments fonctionnels électromécaniques ou électriques (3) sur la couche support (5) et les pistes conductrices (2) sur cette dernière sont stratifiés avec la couche de revêtement (6), **en ce que** les contacts (4) sont sortis par un évidement (8) correspondant de la couche de revêtement (6), **caractérisé en ce qu'**au moins une couche de prépreg polymère (4b) renforcé et une couche de métal (4a) sont précollées en contacts électriquement conducteurs (4) et découpées selon la taille prédéfinie, **en ce que** ces derniers sont alors mis dans l'évidemment (8) correspondant de la couche de revêtement (6) en prépreg polymère renforcé symétriquement et/ou **en ce que** les pistes conductrices (2) électriques y sont disposées et stratifiées sur la couche de revêtement (6) dotée de contacts, et **en ce que** les prépregs sont durcis, par la suite les éléments fonctionnels (3) sont alors fixés au moyen d'une couche support (5) de prépreg polymère renforcé sur les pistes conductrices (2) de la couche de revêtement (6) nettoyée au plasma côté conducteur et métallisée à travers et durcis dans un processus de stratification ultérieur.

3. Procédé selon la revendication 2, **caractérisé en ce que** les pistes conductrices (2) sont appliquées sur une feuille support intermédiaire, **en ce que** les pistes conductrices (2) sont transmises de la feuille support intermédiaire à une feuille polymère sous forme de couche de revêtement (6), **en ce que** la feuille polymère (6) est réalisée à partir d'un prépreg polymère renforcé symétriquement, **en ce que** le prépreg polymère renforcé symétriquement est poinçonné avec des évidements (8) à des positions définies et doté de contacts (4) (pastilles de contact), **en ce que** les contacts (4) sont constitués d'un composite électriquement conducteur en métal (4a) et prépreg polymère (4b) ou d'un prépreg polymère renforcé par treillis métallique ou tissu métallique, **en ce que** le composite de la couche de revêtement (6), des pistes conductrices (2) et des éléments de contact (4) est durci conformément aux paramètres de traitement pour les prépregs en une feuille de carte imprimée polymère plane métallisée à travers (feuille polymère avec pistes conductrices électriques), par la suite cette feuille de carte imprimée polymère est alors nettoyée au plasma côté piste conductrice, par la suite les éléments fonctionnels (3) sont alors fixés au moyen de la couche support (5) renforcée par le prépreg polymère et ce composite est durci dans un processus de stratification ultérieur.

4. Procédé selon la revendication 2, caractérisé en que les pistes conductrices (2) sont appliquées sur une couche de revêtement (6) polymère durcie et métallisée, par la suite la couche de revêtement (6) dotée des pistes conductrices (2) est alors nettoyée au plasma côté piste conductrice, par la suite les éléments fonctionnels (3) sont alors fixés au moyen de la couche support (5) renforcée par le prépreg polymère et ce composite est durci dans un processus de stratification ultérieur.

5. Procédé selon les revendications 2, 3 et 4, **caractérisé en ce que** les éléments fonctionnels (3) sont alignés avec un dispositif de séparation.

6. Procédé selon les revendications 2, 3, 4, 5 et 6, **caractérisé en ce que** les prépregs sont renforcés mécaniquement par des fibres, des cordons, des filaments, du tissu, des non-tissés, du fil ou des treillis en verre, polymère, métal ou carbone et le renforcement mécanique est réglé de façon à ce que soit la dilatation des éléments fonctionnels (3) soit entravée le moins possible ou que le module E pour le convertisseur soit réglé de manière ciblée.

7. Procédé selon l'une des revendications 2 à 5, **caractérisé en ce que** des composants électroniques sont également intégrés sous forme d'éléments fonctionnels (3) via des pistes conductrices (2) contactées au moyen du contact (4) qui se composent à la fois de CMS passifs et actifs et de circuits intégrés.

8. Procédé selon l'une des revendications 2 à 5, **caractérisé en ce qu'**une autre couche fonctionnelle pour le blindage contre le rayonnement électromagnétique, la corrosion et l'eau ou pour le camouflage est stratifiée sur la surface de la couche de revêtement (6) en fibres avant le durcissement.

9. Procédé selon la revendication 8, **caractérisé en ce que** la couche fonctionnelle est une feuille métallique mince et/ou mise à la terre.

10. Procédé selon l'une des revendications 2 à 9, **caractérisé en ce que** la rugosité de la surface du convertisseur (1) est réglée de manière ciblée simple ou double face dans le procédé de stratification.

11. Procédé selon l'une des revendications 2 à 10, **caractérisé en ce qu'**au moins deux éléments fonctionnels (3) ou convertisseur (1) sont connectés en pile.

12. Utilisation d'un convertisseur selon la revendication 1, **caractérisée en ce qu'**un convertisseur (1) est intégré dans un matériau composite renforcé par des fibres ou y est appliqué, de façon à ce qu'une fonctionnalité de capteur et d'actionneur soit obtenue avec lui.

13. Utilisation d'un convertisseur selon la revendication 1, **caractérisée en ce que** le convertisseur (1) est mis en oeuvre dans la plage basse fréquence pour l'analyse modale, la génération d'oscillations, la détection, les capteurs sismiques, l'amortissement d'oscillations ou comme jauge extensométrique dynamique.

14. Utilisation d'un convertisseur selon la revendication 1, **caractérisée en ce que** le convertisseur (1) est mis en oeuvre comme convertisseur acoustique (haut-parleur, microphone) ou convertisseur acoustique hydrostatique (hydrophone).

15. Utilisation d'un convertisseur selon la revendication 1, **caractérisée en ce que** le convertisseur (1) est mis en oeuvre dans la plage haute fréquence pour la génération d'ultrasons et la détection ou pour le contrôle non destructif embarqué ou inspection au moyen d'ondes guidées, de capteurs d'impédance ou de détection d'impact.
